# EUROPEAN PATENT APPLICATION

(11) **EP 1 041 713 A1**
(43) Date of publication of application: **04.10.2000**
(21) Application number: 99830180.8
(22) Date of filing: 30.03.1999
(51) Int. Cl.: H03F 3/30

(54) **Voltage follower circuit**

(71) Applicant: STMicroelectronics S.r.l., 20041 Agrate Brianza (Milano) (IT)
(72) Inventor: Tomasini, Luciano, 20052 Monza (Milano) (IT); Clerici, Giancarlo, 20090 Vimodrone (Milano) (IT)
(74) Representative: Maggioni, Claudio

(57) **Abstract**

A first NPN transistor (Q₁) is connected in the emitter follower configuration with a first PNP transistor (Q₂) as the load element. A second NPN transistor (Q₃), in series with a second PNP transistor (Q₄) connected in diode mode and a current generator (Go), has its base connected to the base of the first NPN transistor (Q1), which is also the input terminal (IN) of the circuit. The base of the first PNP transistor (Q₂) is connected to the connection node (N) between the second PNP transistor (Q₄) and the current generator (Go).

The circuit behaves as an excellent voltage follower with any type of load and requires a negligible use of area when it is formed as part of an integrated circuit.

## Description

The present invention relates to a voltage follower as defined in the preamble of Claim 1.

In the design of complex electronic circuits, it frequently becomes necessary to decouple the output of one stage from the input of a subsequent stage, or to increase the load impedance "seen" from the output of one stage, or to have a higher "current-carrying capacity", in other words the possibility of having an output signal with a higher power than that of the input signal. A well-known circuit which meets these requirements is the voltage follower, also called an emitter follower if it is formed with a bipolar transistor, or a source follower if it is formed with a field-effect transistor.

Figure 1 shows an emitter follower circuit consisting of a bipolar transistor Q of the NPN type, having a current generator G as the emitter load element. The circuit is supplied from a bipolar voltage source (+Vcc, -Vcc), and its input terminals are the base and a reference terminal common to the input and the output, indicated by the earth symbol, and its output terminals are the emitter and the common reference terminal.

Figure 2 shows a similar source follower circuit consisting of an n-channel MOSFET transistor (M₁).

In the case of the source follower, the impedance is approximately that of the input of the MOSFET, and is therefore practically infinite for frequencies lower than the cut-off frequency of the transistor, while in the case of the emitter follower the impedance "seen" from the input depends on the impedance of the load element, in other words, in this example, on the internal resistance of the current generator G, with a multiplication factor practically equal to the current gain of the transistor. Additionally, the output voltage of the circuit is lower than the input voltage by a value equal to the voltage drop of the forward-biased base-emitter junction (Vbe = 0.6-0.7 V) for a bipolar transistor, or equal to the bias voltage in conduction (V_{GS} = 1.2-1.5 V) for the MOSFET transistor.

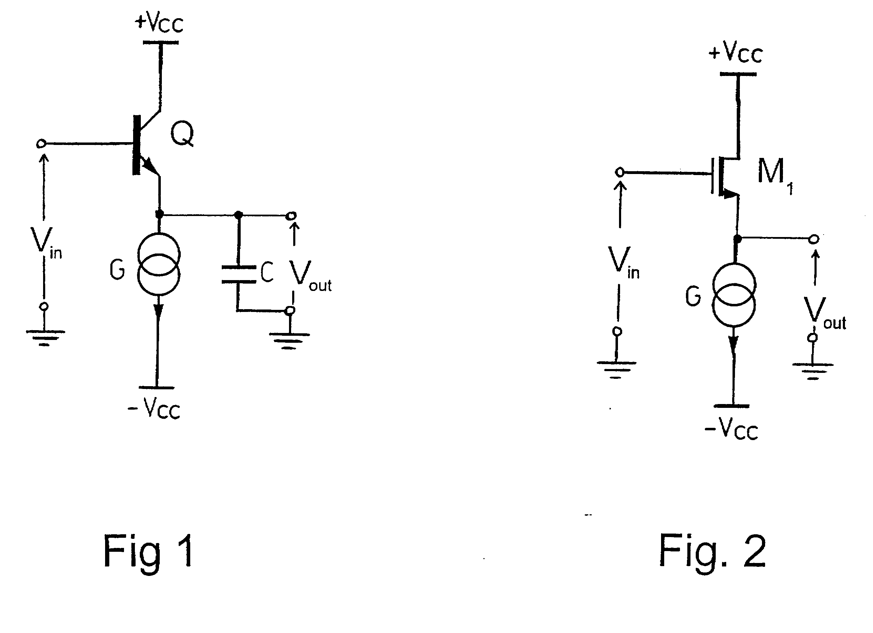

The known voltage follower has a functional characteristic which may become a problem in certain applications, namely that its capacity to supply current to a load connected to its output terminals is asymmetric. This characteristic can easily be demonstrated by considering a capacitive load C as shown in Figure 1.

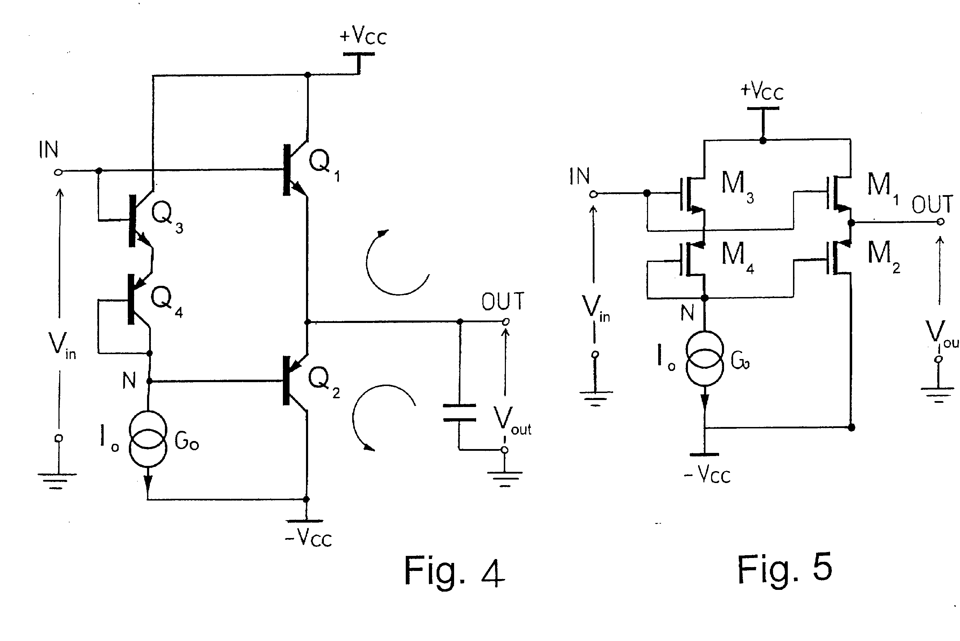

If an input voltage Vin with a triangular waveform variable between -1 V and +1 V, as shown in Figure 3, is applied to the input of the circuit, in other words between the base terminal of the transistor Q and the earth terminal, then at the output there is a voltage Vout which varies from approximately -1.7 V to approximately +0.3 V in the presence of the rising edge of the input voltage and from approximately +0.3 V to approximately -0.3 V in the presence of the falling edge. As may be seen, the deviation between the output voltage Vout and the input voltage Vin is constant and equal to Vbe (forward base-emitter voltage of the transistor Q) in the rising edge, while it is variable in the falling edge until it becomes negative. This behaviour is due to the fact that, when the input voltage is increasing, the conduction of the transistor Q increases and supplies to the capacitor C all the current necessary to charge it, while, when the input voltage is decreasing, the output voltage falls more slowly because the discharge of the capacitor C is limited by the current of the generator G, or, in other words, because the capacitor C has to discharge through the internal resistance of the generator, which is generally very high.

To avoid this problem there is a known way of constructing the voltage follower with an operational amplifier having the inverting terminal connected to the output. This solution is certainly advantageous in functional terms in many applications, but causes an increase in power consumption and requires a considerable area for its formation in an integrated circuit.

The principal object of the present invention is to propose a voltage follower circuit which does not have the asymmetry described above, has a low power consumption and requires a negligible area for its formation in an integrated circuit.

This object is achieved by making the voltage follower circuit as defined and characterized in a general way in Claim 1.

The invention will be more clearly understood from the following detailed description of two embodiments provided by way of example and therefore without restriction, this description referring to the attached drawings, in which:
- Figures 1 and 2 show two voltage followers according to the prior art,
- Figure 3 is a graph which illustrates the operation of the voltage follower according to Figure 1,
- Figures 4 and 5 show two embodiments of the voltage follower according to the invention, and

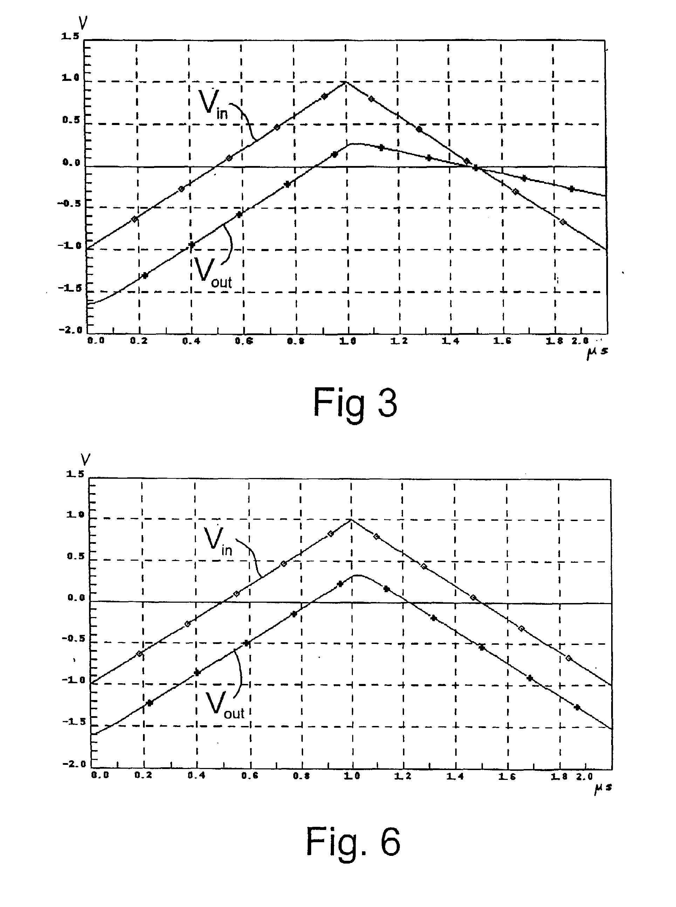

- Figure 6 is a graph which illustrates the operation of the voltage follower according to Figure 4.

The voltage follower circuit according to the invention, as shown in Figure 4, consists substantially of two pairs of complementary bipolar transistors. The first pair comprises an NPN type transistor Q₁ with its collector connected to the positive power supply terminal +Vcc of a power supply source, its base connected to the input terminal IN of the circuit and its emitter connected to the output terminal OUT of the circuit and to the emitter of a PNP type transistor Q₂. The latter transistor has its collector connected to the negative power supply terminal -Vcc and its base connected to a circuit node N, which is the point of connection between the collector of the PNP transistor Q₄ of the other pair of transistors and a current generator Go. The transistor Q₄ is connected in diode mode, in other words with the base joined to the collector, and has its emitter connected to the emitter of the other transistor of the pair, which is an NPN transistor Q₃. The last-mentioned transistor has its base connected to the input terminal IN of the circuit together with the base of the NPN transistor Q₁, and its collector connected to the positive power supply terminal +Vcc.

In direct current operation, the output voltage present between the output terminal OUT and the earth terminal is Vout = Vin -Vbe1, where Vin is the input voltage applied between the input terminal IN and earth, and Vbel is the voltage drop of the base-emitter junction of the transistor Q₁ in the forward direction. The behaviour of the circuit is therefore identical to that of an ordinary emitter follower (Figure 1). By contrast with the known emitter follower, however, the deviation between the input voltage and the output voltage remains approximately constant, even in operation with a variable input voltage and with any type of load.

By way of example, the response of the circuit to a triangular-wave input voltage, with a capacitive load, will be considered. The bases of the transistors Q₁ and Q₃ are biased in such a way that the two transistors are conducting in the absence of a signal. It may be seen that if the NPN transistor Q₃ is conducting the PNP transistor Q₂ is also conducting, since its base is at a more negative voltage than the emitter. It can be verified that substantially identical currents flow through the input branch (Q₃, Q₄) and the output branch (Q₁, Q₂) if the NPN transistors Q₁ and Q₃ and the PNP transistors Q₂ and Q₄ are identical to each other.

If a triangular-wave voltage Vin like that applied to the circuit in Figure 1 is applied to the input, then in the presence of the rising edge of the waveform the output voltage Vout follows the input voltage with a deviation of Vbe1, in other words the voltage drop across the base-emitter junction of the transistor Q₁ in the forward direction (approximately 0.7 V), and the capacitor C is charged by the current supplied by the transistor Q₁. In the presence of the falling edge, the capacitor C can discharge rapidly through the conducting PNP transistor Q₂, and therefore the output voltage Vout can continue to follow the input voltage with a deviation which is again practically equal to Vbel. The real situation differs from the theoretical one, since the collector current of Q₂ is limited by the fact that it depends on a base current Ib2 which is smaller than Io, in other words than the current of the generator Go. This limitation is, however, β times less severe than that of the known voltage follower in Figure 1, where β is the gain of the NPN transistor Q₂.

In the embodiment with MOSFET transistors, this limitation is not present, since the gate current is practically zero (except for parasitic currents).

It can easily be verified that the circuit behaves equally well with a resistive or an inductive load.

From the above description, it will be seen that the voltage follower according to the invention can be formed with a very small use of the area of the integrated circuit, since it requires only three additional transistors, has an extremely low power consumption, acts in all practical applications as an operational amplifier voltage follower, and is perfectly symmetrical.

Although the invention has been illustrated and described with reference to only two embodiments, it is clear that numerous variants and modifications are possible. For example, NPN transistors could be used in place of the PNP transistors, and vice versa, provided of course that the power supply polarity is changed; or p-channel MOSFET transistors could be used in place of the n-channel MOSFET transistors, and vice versa; or, again, the circuit shown in Figure 4 could be modified by using MOSFET transistors in place of the PNP transistors Q₂ and Q₄.

## Claims

1. Voltage follower circuit, comprising a first transistor (Q1) having a first type of conductivity (NPN) and having a first terminal connected to a first power supply terminal (+Vcc) of the circuit, a control terminal connected to an input terminal (IN) of the circuit and a second terminal connected to an output terminal (OUT) of the circuit and, through a load element (Q2), to a second power supply terminal (-Vcc) of the circuit,
characterized in that it comprises a second transistor (Q₃) having the first type of conductivity (NPN) and a third transistor (Q₄) having a second type of conductivity (PNP), the second transistor (Q₃) having a first terminal connected to the first power supply terminal (+Vcc), a control terminal connected to the input terminal (IN) of the circuit and a second terminal, the third transistor (Q₄) having a first terminal and a control terminal connected together, through a current generator (Go), to the second power supply terminal (-Vcc) and a second terminal connected to the second terminal of the second transistor (Q₃) and in that the load element comprises a fourth transistor (Q₂) having the second type of conductivity (PNP) and having a first terminal connected to the second power supply terminal (-Vcc), a second terminal connected to the second terminal of the first transistor (Q₁) and a control terminal connected to the junction point (N) between the first terminal of the third transistor (Q₄) and the current generator (Go) .

2. Circuit according to Claim 1, in which the first (Q₁) and the second (Q₃) transistors are bipolar transistors of the NPN type and the third (Q₄) and the fourth (Q₂) transistors are bipolar transistors of the PNP type; the first terminal, the second terminal and the control terminal of each of the transistors being, respectively, the collector, the emitter and the base of the transistor.

3. Circuit according to Claim 1, in which the first (Q₁) and the second (Q₃) transistors are bipolar transistors of the PNP type and the third (Q₄) and the fourth (Q₂) transistors are bipolar transistors of the NPN type; the first terminal, the second terminal and the control terminal of each of the transistors being, respectively, the collector, the emitter and the base of the transistor.

4. Circuit according to Claim 1, in which the first (Q₁) and the second (Q₃) transistors are bipolar transistors and the third (Q₄) and the fourth (Q₂) transistors are field-effect transistors.
